# EUROPEAN PATENT APPLICATION

(11) **EP 4 016 600 A1**
(43) Date of publication of application: **22.06.2022**
(21) Application number: 21198004.0
(22) Date of filing: 21.09.2021
(51) Int. Cl.: H01L 21/768

(54) **METAL LINES PATTERNED BY BOTTOM-UP FILL METALLIZATION FOR ADVANCED INTEGRATED CIRCUIT STRUCTURE FABRICATION**

(30) Priority: 21.12.2020 US 202017129852
(71) Applicant: INTEL Corporation, Santa Clara, CA 95054 (US)
(72) Inventor: KOBRINSKY, Mauro, Portland, OR 97229 (US); CHEBIAM, Ramanan V, Hillsboro, 97124 (US); CARVER, Colin T, Hillsboro, 97124 (US); LIN, Kevin Lai, Beaverton, 97006 (US)
(74) Representative: HGF

(57) **Abstract**

Embodiments of the disclosure are in the field of integrated circuit structure fabrication. In an example, an integrated circuit structure includes a plurality of conductive interconnect lines above a substrate, individual ones of the conductive interconnect lines having a top and sidewalls. An etch stop layer is on the top and along an entirety of the sidewalls of the individual ones of the conductive interconnect lines.

## Description

### TECHNICAL FIELD

Embodiments of the disclosure are in the field of advanced integrated circuit structure fabrication and, in particular, metal lines patterned by bottom-up fill metallization and the resulting structures.

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant.

Variability in conventional and currently known fabrication processes may limit the possibility to further extend them into the 7 nanometer node or sub-7 nanometer node range. Consequently, fabrication of the functional components needed for future technology nodes may require the introduction of new methodologies or the integration of new technologies in current fabrication processes or in place of current fabrication processes.

### BRIEF DESCRIPTION OF THE DRAWINGS

Figure 1 illustrates a cross-sectional view of a starting structure for a method of fabricating metal lines patterned by bottom-up fill metallization, in accordance with an embodiment of the present disclosure.
Figures 2A-2D illustrate cross-sectional views representing various operations in the method of fabricating metal lines patterned by bottom-up fill metallization, in accordance with an embodiment of the present disclosure.
Figure 3 illustrates a cross-sectional view representing a structure at an operation in the method of fabricating metal lines patterned by bottom-up fill metallization, in accordance with an embodiment of the present disclosure.
Figures 4A-4B illustrate cross-sectional views representing various operations in the method of fabricating metal lines patterned by bottom-up fill metallization, in accordance with an embodiment of the present disclosure.
Figures 5A-5B illustrate cross-sectional views representing various operations in the method of fabricating metal lines patterned by bottom-up fill metallization, in accordance with another embodiment of the present disclosure.
Figure 6 is a schematic of a pitch quartering approach used to fabricate trenches for interconnect structures, in accordance with an embodiment of the present disclosure.
Figure 7 illustrates a cross-sectional view of a metallization layer fabricated using pitch halving scheme above a metallization layer fabricated using pitch quartering scheme, in accordance with an embodiment of the present disclosure.
Figure 8A illustrates a cross-sectional view of an integrated circuit structure having a metallization layer with a metal line composition above a metallization layer with a differing metal line composition, in accordance with an embodiment of the present disclosure.
Figure 8B illustrates a cross-sectional view of an integrated circuit structure having a metallization layer with a metal line composition coupled to a metallization layer with a differing metal line composition, in accordance with an embodiment of the present disclosure.
Figures 9A-9C illustrate cross-section views of individual interconnect lines having various liner and conductive capping structural arrangements, in accordance with an embodiment of the present disclosure.
Figure 10 illustrates a cross-sectional view of an integrated circuit structure having four metallization layers with a metal line composition and pitch above two metallization layers with a differing metal line composition and smaller pitch, in accordance with an embodiment of the present disclosure.
Figure 11 illustrates a computing device in accordance with one implementation of the disclosure.
Figure 12 illustrates an interposer that includes one or more embodiments of the disclosure.
Figure 13 is an isometric view of a mobile computing platform employing an IC fabricated according to one or more processes described herein or including one or more features described herein, in accordance with an embodiment of the present disclosure.
Figure 14 illustrates a cross-sectional view of a flip-chip mounted die, in accordance with an embodiment of the present disclosure.

### DESCRIPTION OF THE EMBODIMENTS

Metal lines patterned by bottom-up fill metallization, and the resulting structures, are described. In the following description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, are not described in detail in order to not unnecessarily obscure embodiments of the present disclosure. Furthermore, it is to be appreciated that the various embodiments shown in the Figures are illustrative representations and are not necessarily drawn to scale.

The following detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, brief summary or the following detailed description.

This specification includes references to "one embodiment" or "an embodiment." The appearances of the phrases "in one embodiment" or "in an embodiment" do not necessarily refer to the same embodiment. Particular features, structures, or characteristics may be combined in any suitable manner consistent with this disclosure.

Terminology. The following paragraphs provide definitions or context for terms found in this disclosure (including the appended claims):

"Comprising." This term is open-ended. As used in the appended claims, this term does not foreclose additional structure or operations.

"Configured To." Various units or components may be described or claimed as "configured to" perform a task or tasks. In such contexts, "configured to" is used to connote structure by indicating that the units or components include structure that performs those task or tasks during operation. As such, the unit or component can be said to be configured to perform the task even when the specified unit or component is not currently operational (e.g., is not on or active). Reciting that a unit or circuit or component is "configured to" perform one or more tasks is expressly intended not to invoke 35 U.S.C. §112, sixth paragraph, for that unit or component.

"First," "Second," etc. As used herein, these terms are used as labels for nouns that they precede, and do not imply any type of ordering (e.g., spatial, temporal, logical, etc.).

"Coupled" - The following description refers to elements or nodes or features being "coupled" together. As used herein, unless expressly stated otherwise, "coupled" means that one element or node or feature is directly or indirectly joined to (or directly or indirectly communicates with) another element or node or feature, and not necessarily mechanically.

In addition, certain terminology may also be used in the following description for the purpose of reference only, and thus are not intended to be limiting. For example, terms such as "upper", "lower", "above", and "below" refer to directions in the drawings to which reference is made. Terms such as "front", "back", "rear", "side", "outboard", and "inboard" describe the orientation or location or both of portions of the component within a consistent but arbitrary frame of reference which is made clear by reference to the text and the associated drawings describing the component under discussion. Such terminology may include the words specifically mentioned above, derivatives thereof, and words of similar import.

"Inhibit" - As used herein, inhibit is used to describe a reducing or minimizing effect. When a component or feature is described as inhibiting an action, motion, or condition it may completely prevent the result or outcome or future state completely. Additionally, "inhibit" can also refer to a reduction or lessening of the outcome, performance, or effect which might otherwise occur. Accordingly, when a component, element, or feature is referred to as inhibiting a result or state, it need not completely prevent or eliminate the result or state.

Embodiments described herein may be directed to front-end-of-line (FEOL) semiconductor processing and structures. FEOL is the first portion of integrated circuit (IC) fabrication where the individual devices (e.g., transistors, capacitors, resistors, etc.) are patterned in the semiconductor substrate or layer. FEOL generally covers everything up to (but not including) the deposition of metal interconnect layers. Following the last FEOL operation, the result is typically a wafer with isolated transistors (e.g., without any wires).

Embodiments described herein may be directed to back end of line (BEOL) semiconductor processing and structures. BEOL is the second portion of IC fabrication where the individual devices (e.g., transistors, capacitors, resistors, etc.) get interconnected with wiring on the wafer, e.g., the metallization layer or layers. BEOL includes contacts, insulating layers (dielectrics), metal levels, and bonding sites for chip-to-package connections. In the BEOL part of the fabrication stage contacts (pads), interconnect wires, vias and dielectric structures are formed. For modern IC processes, more than 10 metal layers may be added in the BEOL.

Embodiments described below may be applicable to FEOL processing and structures, BEOL processing and structures, or both FEOL and BEOL processing and structures. In particular, although an exemplary processing scheme may be illustrated using a FEOL processing scenario, such approaches may also be applicable to BEOL processing. Likewise, although an exemplary processing scheme may be illustrated using a BEOL processing scenario, such approaches may also be applicable to FEOL processing.

It is to be appreciated that FEOL is a technology driver for a given process. In other embodiment, FEOL considerations are driven by BEOL 7 nanometer or sub-7 nanometer processing requirements. For example, material selection and layouts for FEOL layers and devices may need to accommodate BEOL processing. In one such embodiment, material selection and gate stack architectures are selected to accommodate high density metallization of the BEOL layers, e.g., to reduce fringe capacitance in transistor structures formed in the FEOL layers but coupled together by high density metallization of the BEOL layers.

Back end of line (BEOL) layers of integrated circuits commonly include electrically conductive microelectronic structures, which are known in the arts as vias, to electrically connect metal lines or other interconnects above the vias to metal lines or other interconnects below the vias. Vias may be formed by a lithographic process. Representatively, a photoresist layer may be spin coated over a dielectric layer, the photoresist layer may be exposed to patterned actinic radiation through a patterned mask, and then the exposed layer may be developed in order to form an opening in the photoresist layer. Next, an opening for the via may be etched in the dielectric layer by using the opening in the photoresist layer as an etch mask. This opening is referred to as a via opening. Finally, the via opening may be filled with one or more metals or other conductive materials to form the via.

Sizes and the spacing of vias has progressively decreased, and it is expected that in the future the sizes and the spacing of the vias will continue to progressively decrease, for at least some types of integrated circuits (e.g., advanced microprocessors, chipset components, graphics chips, etc.). When patterning extremely small vias with extremely small pitches by such lithographic processes, several challenges present themselves. One such challenge is that the overlay between the vias and the overlying interconnects, and the overlay between the vias and the underlying landing interconnects, generally need to be controlled to high tolerances on the order of a quarter of the via pitch. As via pitches scale ever smaller over time, the overlay tolerances tend to scale with them at an even greater rate than lithographic equipment is able to keep up.

Another such challenge is that the critical dimensions of the via openings generally tend to scale faster than the resolution capabilities of the lithographic scanners. Shrink technologies exist to shrink the critical dimensions of the via openings. However, the shrink amount tends to be limited by the minimum via pitch, as well as by the ability of the shrink process to be sufficiently optical proximity correction (OPC) neutral, and to not significantly compromise line width roughness (LWR) or critical dimension uniformity (CDU), or both. Yet another such challenge is that the LWR or CDU, or both, characteristics of photoresists generally need to improve as the critical dimensions of the via openings decrease in order to maintain the same overall fraction of the critical dimension budget.

The above factors are also relevant for considering placement and scaling of non-conductive spaces or interruptions between metal lines (referred to as "plugs," "dielectric plugs" or "metal line ends" among the metal lines of back end of line (BEOL) metal interconnect structures. Thus, improvements are needed in the area of back end metallization manufacturing technologies for fabricating metal lines, metal vias, and dielectric plugs.

In a first aspect, bottom-up fill metallization defined patterning is described.

Embodiments can be implemented to assist in scaling of copper (Cu) interconnects to smaller dimensions and higher aspect ratio features. Extending Cu interconnects to smaller dimensions can assist with extending Moore's law (density scaling) and further enable achieving lower resistance interconnects at smaller dimensions as low resistance Cu metal is used.

To provide context, Cu interconnect scaling has been performed with seed scaling and increasing fill capability of electroplating additives. However, thin seed coverage at smaller dimensions causes aspect ratio to increase. Higher aspect ratio interconnects can be difficult to fill by electroplating bottom up fill. However, higher aspect ratio can enable better performance of interconnects, hence the need for a good solution. Traditional fill is performed by physical vapor deposition (PVD) Cu seed followed by electroplating fill. At smaller dimensions, achieving a robust, continuous seed is a big challenge and the seed can consume most of the available real estate leaving it extremely difficult to fill by electroplating. As a result, high aspect ratio features may not be accessible, as voids post poor gapfill arise. High Aspect ratio features provide performance benefits at low dimensions which may not be enabled if interconnect gapfill is poor.

In accordance with one or more embodiments of the present disclosure, selective deposition on a patterned substrate is implemented for growth of a metal interconnect material. As there is no seed on the interconnect sidewall and seed is present only at the bottom of the feature, the growth is bottom-up. Once the growth is complete, the metal is polished to reveal the pattern. The dielectric is etched out leaving free standing Cu interconnects. In one embodiment, gapfill is less of a challenge as there is no pinch off from sidewall growth. Embodiments can be implemented to enable the fabrication of Cu interconnects at small dimensions.

Advantages of implementing embodiments described herein can include enabling Cu interconnects at small dimensions and high aspect ratio features. Enabling Cu fill at small dimensions can assist in density scaling. Enabling high aspect ratio fill can assist with achieving improved performance of interconnects of the chip.

Detectibility of embodiments described herein can include the observation that Cu pillars can be covered with an etch stop or an etch stop like material. For example, in cross-sectional SEM, three sides of a Cu line can be covered with a dielectric barrier, and the bottom can have Ta or other barriers. Conversely, normal Damascene interconnects have three sides covered with Ta and a top covered with an etch stop. XSEM/TEM and an EDS map of an interconnect can reveal that Cu is covered by dielectric barrier (e.g., etch stop) on three sides, while the bottom can have a metallic barrier.

In an embodiment, a process flow described herein involves a metal first and dielectric last approach, contrary to traditional patterning in a dielectric and subsequent metal fill. With an approach described herein, with patterning in a sacrificial material on a seed and using the seed to grow Cu in a bottom-up manner, the limitation of bottom-up gapfill can be eliminated. There may be no requirement on seed coverage on the sidewall. An air gap type architecture could also be considered to combine high aspect ratio (AR) interconnects with capacitance dielectric.

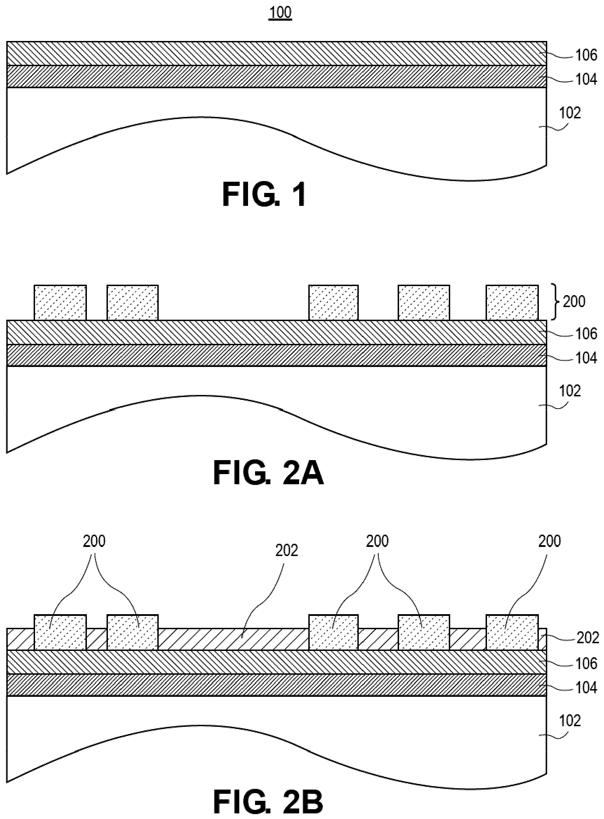

Figure 1 illustrates a cross-sectional view of a starting structure 100 for a method of fabricating metal lines patterned by bottom-up fill metallization, in accordance with an embodiment of the present disclosure. A dielectric layer 104 is on or above a substrate 102. A seed layer 106 is on or above the dielectric layer 104. The seed layer 106 is a blanket seed layer and may be composed of, e.g., Cu, TiN/Ru, Ta/Cu, or Al/Mn

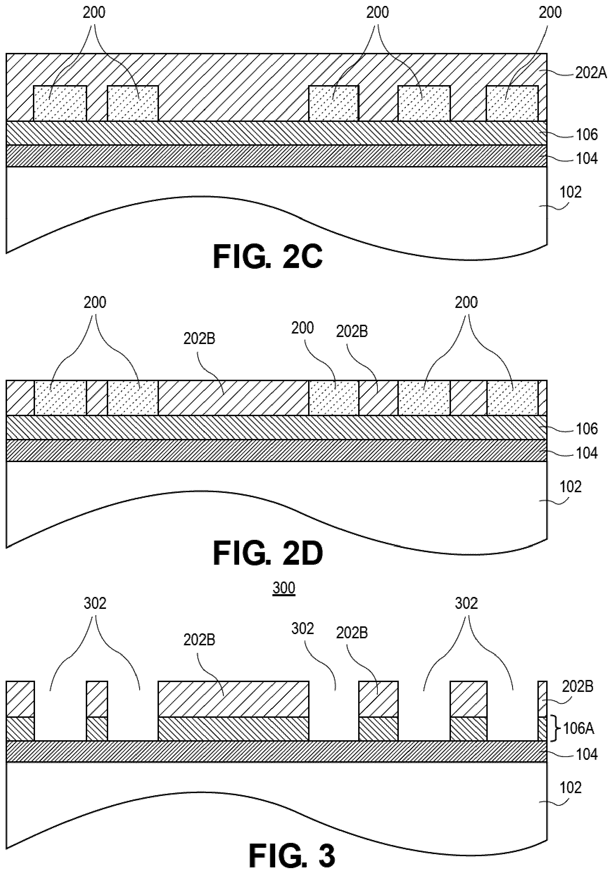

Figures 2A-2D illustrate cross-sectional views representing various operations in the method of fabricating metal lines patterned by bottom-up fill metallization, in accordance with an embodiment of the present disclosure. Referring to Figure 2A, sacrificial material structures 200, such as a patterned or insulative layer, is formed on the seed layer 106 of Figure 1. A conductive fill metal portion 202, such as a copper portion, is then grown on the seed layer 106 using the sacrificial material structures 200 as a guide, as is depicted in Figure 2B. The conductive fill metal portion 202 deposition can be electroless or an electroplating process. The growth is bottom-up templated by the exposed seed layer 106. Referring to Figure 2C, an overburden of the conductive fill metal is formed by overfilling with electroplating or physical vapor deposition to form conductive fill metal structure 202A. The conductive fill metal structure 202A is then planarized, e.g., by chemical mechanical polishing, to form conductive fill structures 202B, as is depicted in Figure 2D. In an embodiment, the conductive fill structures 202B are copper structures. In other embodiments, the conductive fill structures 202B include nickel (Ni), cobalt (Co), ruthenium (Ru), platinum (Pt), iridium (Ir), rhodium (Rh), gold (Au), or silver (Ag), or alloys thereof.

Figure 3 illustrates a cross-sectional view representing a structure 300 at an operation in the method of fabricating metal lines patterned by bottom-up fill metallization, in accordance with an embodiment of the present disclosure. Referring to Figure 3, the sacrificial material structures 200 are removed from the structure of Figure 2D. The seed layer 106 is then etched to form patterned seed layer 106A. Thus, structures are formed including an upper conductive fill structure 202B and a lower patterned seed layer portion 106A, each of the structures separated by a trench 302.

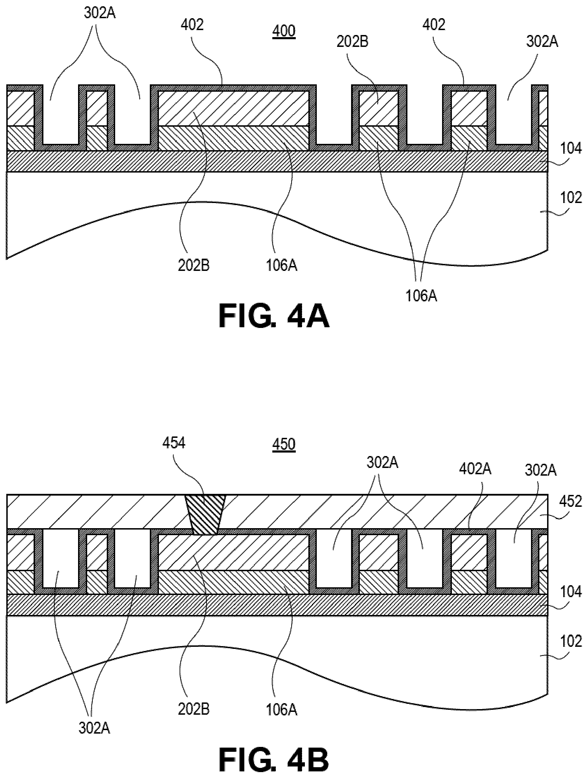

In a first example, Figures 4A-4B illustrate cross-sectional views representing various operations in the method of fabricating metal lines patterned by bottom-up fill metallization, in accordance with an embodiment of the present disclosure. Referring to Figure 4A, a structure 400 is formed by depositing an etch stop layer 402 over the structure of Figure 3. An inter-layer dielectric layer (ILD) layer 452 is then formed on the structure of Figure 4A to form structure 450, as is depicted in Figure 4B. As depicted, the ILD layer 452 is formed without filling the remaining portions 302A of the trenches 302, leaving air gaps 302A. A conductive via 454 can then be formed in ILD layer 452 and in etch stop layer 402 (forming patterned etch stop layer 402A) to contact one of the conductive fill structure 202B, as is also depicted, e.g., to enable interconnection to an overlying interconnect layer.

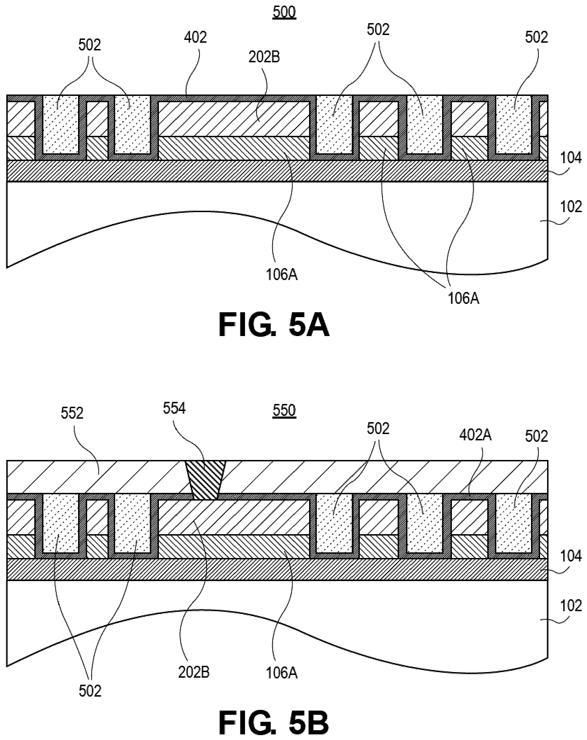

In a second example, Figures 5A-5B illustrate cross-sectional views representing various operations in the method of fabricating metal lines patterned by bottom-up fill metallization, in accordance with another embodiment of the present disclosure. Referring to Figure 5A, a structure 500 is formed by depositing an etch stop layer 402 over the structure of Figure 3, and then forming a dielectric material 502 (such as a low-k dielectric layer) in the remaining portions of the trenches 302. An inter-layer dielectric layer (ILD) layer 552 is then formed on the structure of Figure 5A to form structure 550, as is depicted in Figure 5B. A conductive via 554 can then be formed in ILD layer 452 and in etch stop layer 402 (forming patterned etch stop layer 402A) to contact one of the conductive fill structure 202B, as is also depicted, e.g., to enable interconnection to an overlying interconnect layer.

In accordance with an embodiment of the present disclosure, with reference again to Figures 4B and 5B, an integrated circuit structure 450 or 550 includes a plurality of conductive interconnect lines 202B/106A above a substrate 102. Individual ones of the conductive interconnect lines 202B/106A have a top and sidewalls. An etch stop layer 402A is on the top and along an entirety of the sidewalls of the individual ones of the conductive interconnect lines 202B/106A.

In an embodiment, the individual ones of the conductive interconnect lines 202B/106A include a conductive fill layer 202B on a seed layer 106A. In one embodiment, the conductive fill layer 202B includes a metal selected from the group consisting of Cu, Ni, Co, Ru, Pt and Ir. In one embodiment, the seed layer 106A includes titanium nitride and ruthenium. In one embodiment, the seed layer 106A includes tantalum and copper.

In an embodiment, with particular reference to Figure 5B, the integrated circuit structure 550 further includes an inter-layer dielectric (ILD) material 502 between adjacent ones of the individual ones of the conductive interconnect lines 202B/106A. The ILD material 502 is laterally adjacent to and in contact with the portion of the etch stop layer 402A along the entirety of the sidewalls of the individual ones of the conductive interconnect lines 202B/106A. In another embodiment, with particular reference to Figure 4B, the integrated circuit structure 450 further includes an air gap 302A between adjacent ones of the individual ones of the conductive interconnect lines 202B/106A. The air gap 302A is laterally adjacent to the portion of the etch stop layer 402A along the entirety of the sidewalls of the individual ones of the conductive interconnect lines 202B/106A.

In an embodiment, the integrated circuit structure 450 or 550 further includes an inter-layer dielectric (ILD) layer 452 or 552 on and in contact with the portion of the etch stop layer 402A along the top surfaces of the individual ones of the conductive interconnect lines 202B/106A. In one such embodiment, the integrated circuit structure 450 or 550 further includes a conductive via 454 or 554 in an opening through the ILD layer 452 or 552 and through the etch sop layer 402A. The conductive via 454 or 554 is in contact with one of the individual ones of the conductive interconnect lines 202B/106A.

In another aspect, a pitch quartering approach is implemented for patterning sacrificial material structures (such as sacrificial material structures 200) above a seed layer for forming BEOL interconnect structures. In accordance with an embodiment of the present disclosure, pitch division is applied for fabricating metal lines in a BEOL fabrication scheme. Embodiments may enable continued scaling of the pitch of metal layers beyond the resolution capability of state-of-the art lithography equipment.

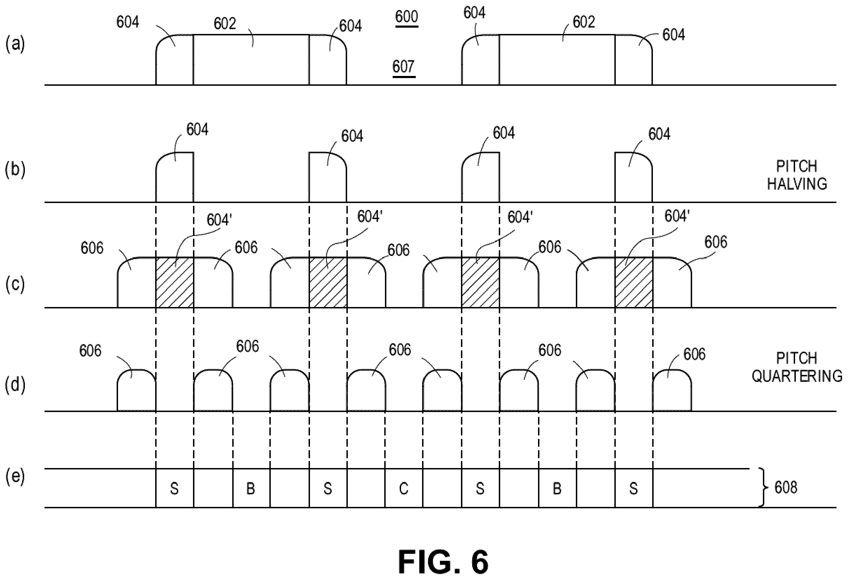

Figure 6 is a schematic of a pitch quartering approach 600 used to fabricate sacrificial material structures for ultimately forming interconnect structures, in accordance with an embodiment of the present disclosure.

Referring to Figure 6, at operation (a), backbone features 602 are formed using direct lithography. For example, a photoresist layer or stack may be patterned and the pattern transferred into a hardmask material to ultimately form backbone features 602. The photoresist layer or stack used to form backbone features 602 may be patterned using standard lithographic processing techniques, such as 193 immersion lithography. First spacer features 604 are then formed adjacent the sidewalls of the backbone features 602.

At operation (b), the backbone features 602 are removed to leave only the first spacer features 604 remaining. At this stage, the first spacer features 604 are effectively a half pitch mask, e.g., representing a pitch halving process. The first spacer features 604 can either be used directly for a pitch quartering process, or the pattern of the first spacer features 604 may first be transferred into a new hardmask material, where the latter approach is depicted.

At operation (c), the pattern of the first spacer features 604 transferred into a new hardmask material to form first spacer features 604'. Second spacer features 606 are then formed adjacent the sidewalls of the first spacer features 604'.

At operation (d), the first spacer features 604' are removed to leave only the second spacer features 606 remaining. At this stage, the second spacer features 606 are effectively a quarter pitch mask, e.g., representing a pitch quartering process.

At operation (e), the second spacer features 606 are used as sacrificial material structures (sacrificial material structures 200) in a bottom-up approach to ultimately form conductive interconnects 608 in a metallization layer of an integrated circuit. Conductive interconnects 608 having the label "B" correspond to backbone features 602. Conductive interconnects 608 having the label "S" correspond to first spacer features 604 or 604'. Conductive interconnects 608 having the label "C" correspond to a complementary region 607 between backbone features 602.

It is to be appreciated that since individual ones of the conductive interconnects 608 of Figure 6 have a patterning origin that corresponds to one of backbone features 602, first spacer features 604 or 604', or complementary region 607 of Figure 6, differences in width and/or pitch of such features may appear as artifacts of a pitch quartering process in ultimately formed conductive interconnects in metallization layers of an integrated circuit.

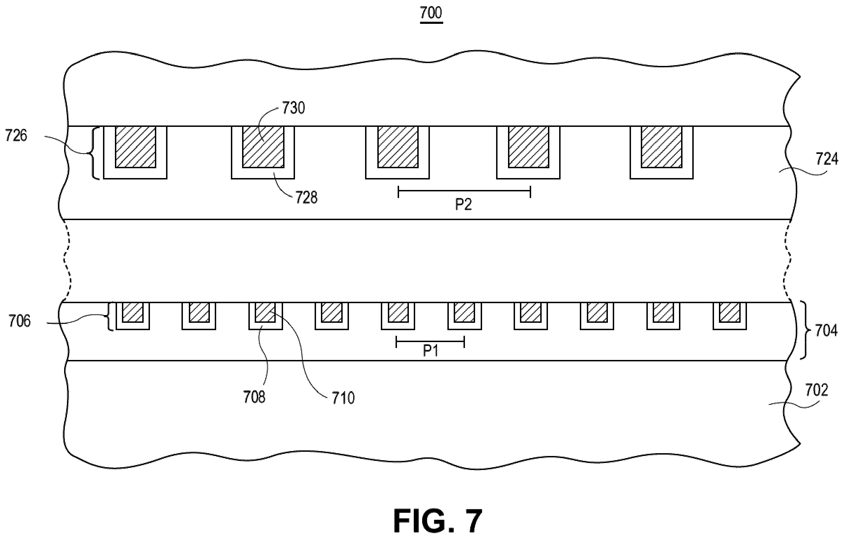

In another aspect, Figure 7 illustrates a cross-sectional view of a metallization layer fabricated using pitch halving scheme above a metallization layer fabricated using pitch quartering scheme, in accordance with an embodiment of the present disclosure. In accordance with an embodiment of the present disclosure, any one or all of the pluralities of interconnects described below in association with Figure 7 can be substituted with a plurality of bottom-up fill metallization structures described above in association with Figures 4B and 4C.

Referring to Figure 7, an integrated circuit structure 700 includes a first inter-layer dielectric (ILD) layer 704 above a substrate 702. A first plurality of conductive interconnect lines 706 is in the first ILD layer 704, and individual ones of the first plurality of conductive interconnect lines 706 are spaced apart from one another by portions of the first ILD layer 704. Individual ones of the plurality of conductive interconnect lines 706 includes a conductive barrier layer 708 and a conductive fill material 710. The integrated circuit structure 700 further includes a second inter-layer dielectric (ILD) layer 724 above substrate 702. A second plurality of conductive interconnect lines 726 is in the second ILD layer 724, and individual ones of the second plurality of conductive interconnect lines 726 are spaced apart from one another by portions of the second ILD layer 724. Individual ones of the plurality of conductive interconnect lines 726 includes a conductive barrier layer 728 and a conductive fill material 730.

In accordance with an embodiment of the present disclosure, with reference again to Figure 7, a method of fabricating an integrated circuit structure includes forming a first plurality of conductive interconnect lines 706 in and spaced apart by a first inter-layer dielectric (ILD) layer 704 above a substrate 702. The first plurality of conductive interconnect lines 706 is formed using a spacer-based pitch quartering process, e.g., the approach described in association with operations (a)-(e) of Figure 6. A second plurality of conductive interconnect lines 726 is formed in and is spaced apart by a second ILD layer 724 above the first ILD layer 704. The second plurality of conductive interconnect lines 726 is formed using a spacer-based pitch halving process, e.g., the approach described in association with operations (a) and (b) of Figure 6.

In an embodiment, first plurality of conductive interconnect lines 706 has a pitch (PI) between immediately adjacent lines of than 40 nanometers. The second plurality of conductive interconnect lines 726 has a pitch (P2) between immediately adjacent lines of 44 nanometers or greater. In an embodiment, the spacer-based pitch quartering process and the spacer-based pitch halving process are based on an immersion 193nm lithography process.

In an embodiment, individual ones of the first plurality of conductive interconnect lines 704 include a first conductive barrier liner 708 and a first conductive fill material 710. Individual ones of the second plurality of conductive interconnect lines 706 include a second conductive barrier liner 728 and a second conductive fill material 730. In one such embodiment, the first conductive fill material 710 is different in composition from the second conductive fill material 730. In another embodiment, the first conductive fill material 710 is the same in composition as the second conductive fill material 730.

In another aspect, metal line compositions vary between metallization layers. Such an arrangement may be referred to as heterogeneous metallization layers. In an embodiment, copper is used as a conductive fill material for relatively larger interconnect lines, while cobalt is used as a conductive fill material for relatively smaller interconnect lines. The smaller lines having cobalt as a fill material may provide reduced electromigration while maintaining low resistivity. The use of cobalt in place of copper for smaller interconnect lines may address issues with scaling copper lines, where a conductive barrier layer consumes a greater amount of an interconnect volume and copper is reduced, essentially hindering advantages normally associated with a copper interconnect line.

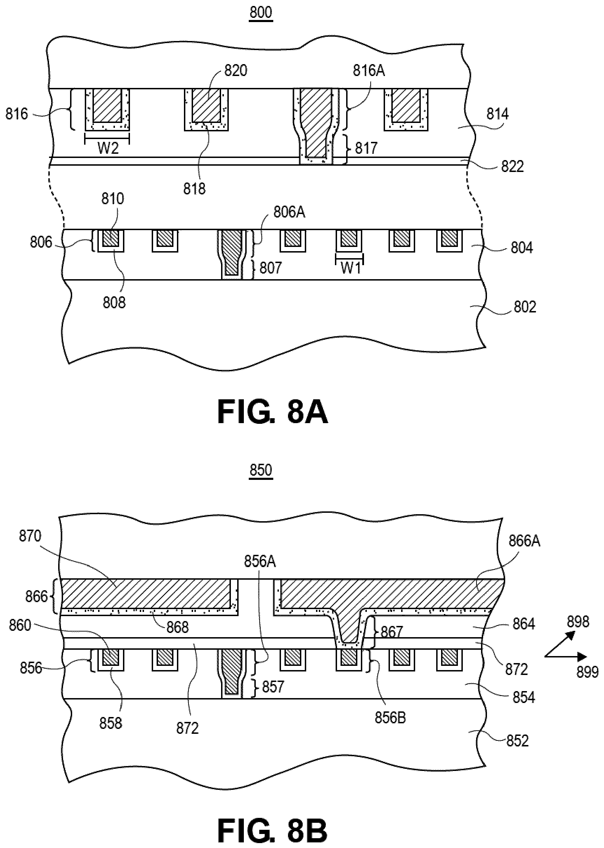

In a first example, Figure 8A illustrates a cross-sectional view of an integrated circuit structure having a metallization layer with a metal line composition above a metallization layer with a differing metal line composition, in accordance with an embodiment of the present disclosure. In accordance with an embodiment of the present disclosure, any one or all of the pluralities of interconnects described below in association with Figure 8A can be substituted with a plurality of bottom-up fill metallization structures described above in association with Figures 4B and 4C.

Referring to Figure 8A, an integrated circuit structure 800 includes a first plurality of conductive interconnect lines 806 in and spaced apart by a first inter-layer dielectric (ILD) layer 804 above a substrate 802. One of the conductive interconnect lines 806A is shown as having an underlying via 807. Individual ones of the first plurality of conductive interconnect lines 806 include a first conductive barrier material 808 along sidewalls and a bottom of a first conductive fill material 810.

A second plurality of conductive interconnect lines 816 is in and spaced apart by a second ILD layer 814 above the first ILD layer 804. One of the conductive interconnect lines 816A is shown as having an underlying via 817. Individual ones of the second plurality of conductive interconnect lines 816 include a second conductive barrier material 818 along sidewalls and a bottom of a second conductive fill material 820. The second conductive fill material 820 is different in composition from the first conductive fill material 810.

In an embodiment, the second conductive fill material 820 consists essentially of copper, and the first conductive fill material 810 consists essentially of cobalt. In one such embodiment, the first conductive barrier material 808 is different in composition from the second conductive barrier material 818. In another such embodiment, the first conductive barrier material 808 is the same in composition as the second conductive barrier material 818.

In an embodiment, the first conductive fill material 810 includes copper having a first concentration of a dopant impurity atom, and the second conductive fill material 820 includes copper having a second concentration of the dopant impurity atom. The second concentration of the dopant impurity atom is less than the first concentration of the dopant impurity atom. In one such embodiment, the dopant impurity atom is selected from the group consisting of aluminum (Al) and manganese (Mn). In an embodiment, the first conductive barrier material 810 and the second conductive barrier material 820 have the same composition. In an embodiment, the first conductive barrier material 810 and the second conductive barrier material 820 have a different composition.

Referring again to Figure 8A, the second ILD layer 814 is on an etch-stop layer 822. The conductive via 817 is in the second ILD layer 814 and in an opening of the etch-stop layer 822. In an embodiment, the first and second ILD layers 804 and 814 include silicon, carbon and oxygen, and the etch-stop layer 822 includes silicon and nitrogen. In an embodiment, individual ones of the first plurality of conductive interconnect lines 806 have a first width (W1), and individual ones of the second plurality of conductive interconnect lines 816 have a second width (W2) greater than the first width (W1).

In a second example, Figure 8B illustrates a cross-sectional view of an integrated circuit structure having a metallization layer with a metal line composition coupled to a metallization layer with a differing metal line composition, in accordance with an embodiment of the present disclosure. In accordance with an embodiment of the present disclosure, any one or all of the pluralities of interconnects described below in association with Figure 8B can be substituted with a plurality of bottom-up fill metallization structures described above in association with Figures 4B and 4C.

Referring to Figure 8B, an integrated circuit structure 850 includes a first plurality of conductive interconnect lines 856 in and spaced apart by a first inter-layer dielectric (ILD) layer 854 above a substrate 852. One of the conductive interconnect lines 856A is shown as having an underlying via 857. Individual ones of the first plurality of conductive interconnect lines 856 include a first conductive barrier material 858 along sidewalls and a bottom of a first conductive fill material 860.

A second plurality of conductive interconnect lines 866 is in and spaced apart by a second ILD layer 864 above the first ILD layer 854. One of the conductive interconnect lines 866A is shown as having an underlying via 867. Individual ones of the second plurality of conductive interconnect lines 866 include a second conductive barrier material 868 along sidewalls and a bottom of a second conductive fill material 870. The second conductive fill material 870 is different in composition from the first conductive fill material 860.

In an embodiment, the conductive via 857 is on and electrically coupled to an individual one 856B of the first plurality of conductive interconnect lines 856, electrically coupling the individual one 866A of the second plurality of conductive interconnect lines 866 to the individual one 856B of the first plurality of conductive interconnect lines 856. In an embodiment, individual ones of the first plurality of conductive interconnect lines 856 are along a first direction 898 (e.g., into and out of the page), and individual ones of the second plurality of conductive interconnect lines 866 are along a second direction 899 orthogonal to the first direction 898, as is depicted. In an embodiment, the conductive via 867 includes the second conductive barrier material 868 along sidewalls and a bottom of the second conductive fill material 870, as is depicted.

In an embodiment, the second ILD layer 864 is on an etch-stop layer 872 on the first ILD layer 854. The conductive via 867 is in the second ILD layer 864 and in an opening of the etch-stop layer 872. In an embodiment, the first and second ILD layers 854 and 864 include silicon, carbon and oxygen, and the etch-stop layer 872 includes silicon and nitrogen. In an embodiment, individual ones of the first plurality of conductive interconnect lines 856 have a first width (W1), and individual ones of the second plurality of conductive interconnect lines 866 have a second width (W2) greater than the first width (W1).

In an embodiment, the second conductive fill material 870 consists essentially of copper, and the first conductive fill material 860 consists essentially of cobalt. In one such embodiment, the first conductive barrier material 858 is different in composition from the second conductive barrier material 868. In another such embodiment, the first conductive barrier material 858 is the same in composition as the second conductive barrier material 868.

In an embodiment, the first conductive fill material 860 includes copper having a first concentration of a dopant impurity atom, and the second conductive fill material 870 includes copper having a second concentration of the dopant impurity atom. The second concentration of the dopant impurity atom is less than the first concentration of the dopant impurity atom. In one such embodiment, the dopant impurity atom is selected from the group consisting of aluminum (Al) and manganese (Mn). In an embodiment, the first conductive barrier material 860 and the second conductive barrier material 870 have the same composition. In an embodiment, the first conductive barrier material 860 and the second conductive barrier material 870 have a different composition.

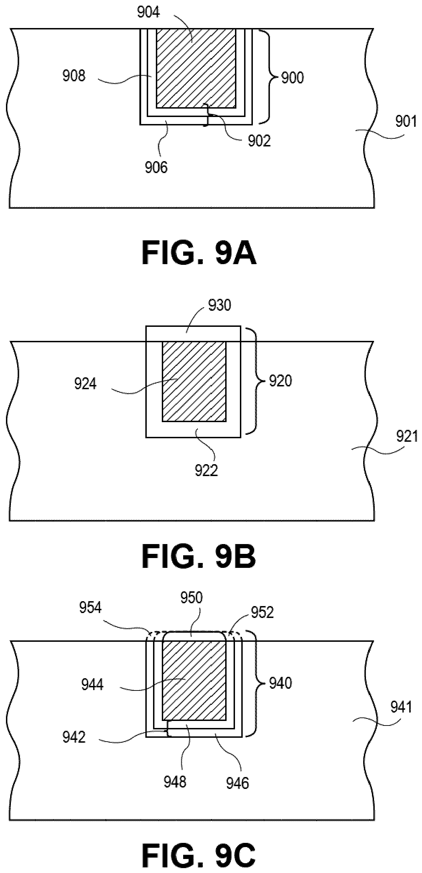

Figures 9A-9C illustrate cross-section views of individual interconnect lines having various barrier liner and conductive capping structural arrangements suitable for the structures described in association with Figures 8A and 8B, in accordance with an embodiment of the present disclosure. In an embodiment, bottom-up fill metallization structure described above in association with Figures 4B and 4C is coupled to an interconnect of Figures 9A-9C by a via structure.

Referring to Figure 9A, an interconnect line 900 in a dielectric layer 901 includes a conductive barrier material 902 and a conductive fill material 904. The conductive barrier material 902 includes an outer layer 906 distal from the conductive fill material 904 and an inner layer 908 proximate to the conductive fill material 904. In an embodiment, the conductive fill material includes cobalt, the outer layer 906 includes titanium and nitrogen, and the inner layer 908 includes tungsten, nitrogen and carbon. In one such embodiment, the outer layer 906 has a thickness of approximately 2 nanometers, and the inner layer 908 has a thickness of approximately 0.5 nanometers. In another embodiment, the conductive fill material includes cobalt, the outer layer 906 includes tantalum, and the inner layer 908 includes ruthenium. In one such embodiment, the outer layer 906 further includes nitrogen.

Referring to Figure 9B, an interconnect line 920 in a dielectric layer 921 includes a conductive barrier material 922 and a conductive fill material 924. A conductive cap layer 930 is on a top of the conductive fill material 924. In one such embodiment, the conductive cap layer 930 is further on a top of the conductive barrier material 922, as is depicted. In another embodiment, the conductive cap layer 930 is not on a top of the conductive barrier material 922. In an embodiment, the conductive cap layer 930 consists essentially of cobalt, and the conductive fill material 924 consists essentially of copper.

Referring to Figure 9C, an interconnect line 940 in a dielectric layer 941 includes a conductive barrier material 942 and a conductive fill material 944. The conductive barrier material 942 includes an outer layer 946 distal from the conductive fill material 944 and an inner layer 948 proximate to the conductive fill material 944. A conductive cap layer 950 is on a top of the conductive fill material 944. In one embodiment, the conductive cap layer 950 is only a top of the conductive fill material 944. In another embodiment, however, the conductive cap layer 950 is further on a top of the inner layer 948 of the conductive barrier material 942, i.e., at location 952. In one such embodiment, the conductive cap layer 950 is further on a top of the outer layer 946 of the conductive barrier material 942, i.e., at location 954.

In an embodiment, with reference to Figures 9B and 9C, a method of fabricating an integrated circuit structure includes forming an inter-layer dielectric (ILD) layer 921 or 941 above a substrate. A plurality of conductive interconnect lines 920 or 940 is formed in trenches in and spaced apart by the ILD layer, individual ones of the plurality of conductive interconnect lines 920 or 940 in a corresponding one of the trenches. The plurality of conductive interconnect lines is formed by first forming a conductive barrier material 922 or 942 on bottoms and sidewalls of the trenches, and then forming a conductive fill material 924 or 944 on the conductive barrier material 922 or 942, respectively, and filling the trenches, where the conductive barrier material 922 or 942 is along a bottom of and along sidewalls of the conductive fill material 924 or 944, respectively. The top of the conductive fill material 924 or 944 is then treated with a gas including oxygen and carbon. Subsequent to treating the top of the conductive fill material 924 or 944 with the gas including oxygen and carbon, a conductive cap layer 930 or 950 is formed on the top of the conductive fill material 924 or 944, respectively.

In one embodiment, treating the top of the conductive fill material 924 or 944 with the gas including oxygen and carbon includes treating the top of the conductive fill material 924 or 944 with carbon monoxide (CO). In one embodiment, the conductive fill material 924 or 944 includes copper, and forming the conductive cap layer 930 or 950 on the top of the conductive fill material 924 or 944 includes forming a layer including cobalt using chemical vapor deposition (CVD). In one embodiment, the conductive cap layer 930 or 950 is formed on the top of the conductive fill material 924 or 944, but not on a top of the conductive barrier material 922 or 942.

In one embodiment, forming the conductive barrier material 922 or 944 includes forming a first conductive layer on the bottoms and sidewalls of the trenches, the first conductive layer including tantalum. A first portion of the first conductive layer is first formed using atomic layer deposition (ALD) and then a second portion of the first conductive layer is then formed using physical vapor deposition (PVD). In one such embodiment, forming the conductive barrier material further includes forming a second conductive layer on the first conductive layer on the bottoms and sidewalls of the trenches, the second conductive layer including ruthenium, and the conductive fill material including copper. In one embodiment, the first conductive layer further includes nitrogen.

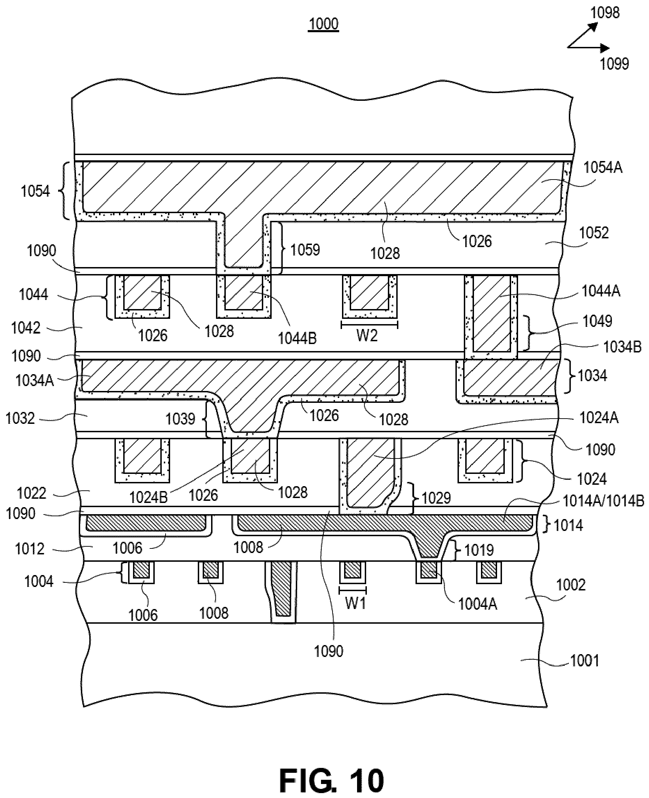

Figure 10 illustrates a cross-sectional view of an integrated circuit structure having four metallization layers with a metal line composition and pitch above two metallization layers with a differing metal line composition and smaller pitch, in accordance with an embodiment of the present disclosure. In accordance with an embodiment of the present disclosure, any one or all of the pluralities of interconnects described below in association with Figure 10 can be substituted with a plurality of bottom-up fill metallization structures described above in association with Figures 4B and 4C.

Referring to Figure 10, an integrated circuit structure 1000 includes a first plurality of conductive interconnect lines 1004 in and spaced apart by a first inter-layer dielectric (ILD) layer 1002 above a substrate 1001. Individual ones of the first plurality of conductive interconnect lines 1004 include a first conductive barrier material 1006 along sidewalls and a bottom of a first conductive fill material 1008. Individual ones of the first plurality of conductive interconnect lines 1004 are along a first direction 1098 (e.g., into and out of the page).

A second plurality of conductive interconnect lines 1014 is in and spaced apart by a second ILD layer 1012 above the first ILD layer 1002. Individual ones of the second plurality of conductive interconnect lines 1014 include the first conductive barrier material 1006 along sidewalls and a bottom of the first conductive fill material 1008. Individual ones of the second plurality of conductive interconnect lines 1014 are along a second direction 1099 orthogonal to the first direction 1098.

A third plurality of conductive interconnect lines 1024 is in and spaced apart by a third ILD layer 1022 above the second ILD layer 1012. Individual ones of the third plurality of conductive interconnect lines 1024 include a second conductive barrier material 1026 along sidewalls and a bottom of a second conductive fill material 1028. The second conductive fill material 1028 is different in composition from the first conductive fill material 1008. Individual ones of the third plurality of conductive interconnect lines 1024 are along the first direction 1098.

A fourth plurality of conductive interconnect lines 1034 is in and spaced apart by a fourth ILD layer 1032 above the third ILD layer 1022. Individual ones of the fourth plurality of conductive interconnect lines 1034 include the second conductive barrier material 1026 along sidewalls and a bottom of the second conductive fill material 1028. Individual ones of the fourth plurality of conductive interconnect lines 1034 are along the second direction 1099.

A fifth plurality of conductive interconnect lines 1044 is in and spaced apart by a fifth ILD layer 1042 above the fourth ILD layer 1032. Individual ones of the fifth plurality of conductive interconnect lines 1044 include the second conductive barrier material 1026 along sidewalls and a bottom of the second conductive fill material 1028. Individual ones of the fifth plurality of conductive interconnect lines 1044 are along the first direction 1098.

A sixth plurality of conductive interconnect lines 1054 is in and spaced apart by a sixth ILD layer 1052 above the fifth ILD layer. Individual ones of the sixth plurality of conductive interconnect lines 1054 include the second conductive barrier material 1026 along sidewalls and a bottom of the second conductive fill material 1028. Individual ones of the sixth plurality of conductive interconnect lines 1054 are along the second direction 1099.

In an embodiment, the second conductive fill material 1028 consists essentially of copper, and the first conductive fill material 1008 consists essentially of cobalt. In an embodiment, the first conductive fill material 1008 includes copper having a first concentration of a dopant impurity atom, and the second conductive fill material 1028 includes copper having a second concentration of the dopant impurity atom, the second concentration of the dopant impurity atom less than the first concentration of the dopant impurity atom.

In an embodiment, the first conductive barrier material 1006 is different in composition from the second conductive barrier material 1026. In another embodiment, the first conductive barrier material 1006 and the second conductive barrier material 1026 have the same composition.

In an embodiment, a first conductive via 1019 is on and electrically coupled to an individual one 1004A of the first plurality of conductive interconnect lines 1004. An individual one 1014A of the second plurality of conductive interconnect lines 1014 is on and electrically coupled to the first conductive via 1019.

A second conductive via 1029 is on and electrically coupled to an individual one 1014B of the second plurality of conductive interconnect lines 1014. An individual one 1024A of the third plurality of conductive interconnect lines 1024 is on and electrically coupled to the second conductive via 1029.

A third conductive via 1039 is on and electrically coupled to an individual one 1024B of the third plurality of conductive interconnect lines 1024. An individual one 1034A of the fourth plurality of conductive interconnect lines 1034 is on and electrically coupled to the third conductive via 1039.

A fourth conductive via 1049 is on and electrically coupled to an individual one 1034B of the fourth plurality of conductive interconnect lines 1034. An individual one 1044A of the fifth plurality of conductive interconnect lines 1044 is on and electrically coupled to the fourth conductive via 1049.

A fifth conductive via 1059 is on and electrically coupled to an individual one 1044B of the fifth plurality of conductive interconnect lines 1044. An individual one 1054A of the sixth plurality of conductive interconnect lines 1054 is on and electrically coupled to the fifth conductive via 1059.

In one embodiment, the first conductive via 1019 includes the first conductive barrier material 1006 along sidewalls and a bottom of the first conductive fill material 1008. The second 1029, third 1039, fourth 1049 and fifth 1059 conductive vias include the second conductive barrier material 1026 along sidewalls and a bottom of the second conductive fill material 1028.

In an embodiment, the first 1002, second 1012, third 1022, fourth 1032, fifth 1042 and sixth 1052 ILD layers are separated from one another by a corresponding etch-stop layer 1090 between adjacent ILD layers. In an embodiment, the first 1002, second 1012, third 1022, fourth 1032, fifth 1042 and sixth 1052 ILD layers include silicon, carbon and oxygen.

In an embodiment, individual ones of the first 1004 and second 1014 pluralities of conductive interconnect lines have a first width (W1). Individual ones of the third 1024, fourth 1034, fifth 1044 and sixth 1054 pluralities of conductive interconnect lines have a second width (W2) greater than the first width (W1).

It is to be appreciated that the layers and materials described above in association with back end of line (BEOL) structures and processing may be formed on or above an underlying semiconductor substrate or structure, such as underlying device layer(s) of an integrated circuit. In an embodiment, an underlying semiconductor substrate represents a general workpiece object used to manufacture integrated circuits. The semiconductor substrate often includes a wafer or other piece of silicon or another semiconductor material. Suitable semiconductor substrates include, but are not limited to, single crystal silicon, polycrystalline silicon and silicon on insulator (SOI), as well as similar substrates formed of other semiconductor materials, such as substrates including germanium, carbon, or group III-V materials. The semiconductor substrate, depending on the stage of manufacture, often includes transistors, integrated circuitry, and the like. The substrate may also include semiconductor materials, metals, dielectrics, dopants, and other materials commonly found in semiconductor substrates. Furthermore, the structures depicted may be fabricated on underlying lower level interconnect layers.

Although the preceding methods of fabricating a metallization layer, or portions of a metallization layer, of a BEOL metallization layer are described in detail with respect to select operations, it is to be appreciated that additional or intermediate operations for fabrication may include standard microelectronic fabrication processes such as lithography, etch, thin films deposition, planarization (such as chemical mechanical polishing (CMP)), diffusion, metrology, the use of sacrificial layers, the use of etch stop layers, the use of planarization stop layers, or any other associated action with microelectronic component fabrication. Also, it is to be appreciated that the process operations described for the preceding process flows may be practiced in alternative sequences, not every operation need be performed or additional process operations may be performed or both.

In an embodiment, as used throughout the present description, interlayer dielectric (ILD) material described herein is composed of or includes a layer of a dielectric or insulating material. Examples of suitable dielectric materials include, but are not limited to, oxides of silicon (e.g., silicon dioxide (SiO₂)), doped oxides of silicon, fluorinated oxides of silicon, carbon doped oxides of silicon, various low-k dielectric materials known in the arts, and combinations thereof. The interlayer dielectric material may be formed by techniques, such as, for example, chemical vapor deposition (CVD), physical vapor deposition (PVD), or by other deposition methods.

In an embodiment, as is also used throughout the present description, metal lines or interconnect line material (and via material) is composed of one or more metal or other conductive structures. A common example is the use of copper lines and structures that may or may not include barrier layers between the copper and surrounding ILD material. As used herein, the term metal includes alloys, stacks, and other combinations of multiple metals. For example, the metal interconnect lines may include barrier layers (e.g., layers including one or more of Ta, TaN, Ti or TiN), stacks of different metals or alloys, etc. Thus, the interconnect lines may be a single material layer, or may be formed from several layers, including conductive liner layers and fill layers. Any suitable deposition process, such as electroplating, chemical vapor deposition or physical vapor deposition, may be used to form interconnect lines. In an embodiment, the interconnect lines are composed of a conductive material such as, but not limited to, Cu, Al, Ti, Zr, Hf, V, Ru, Co, Ni, Pd, Pt, W, Ag, Au or alloys thereof. The interconnect lines are also sometimes referred to in the art as traces, wires, lines, metal, or simply interconnect.

In an embodiment, as is also used throughout the present description, hardmask materials or dielectric barrier layers or etch stop layers are composed of dielectric materials different from the interlayer dielectric material. In one embodiment, different hardmask materials may be used in different regions so as to provide different growth or etch selectivity to each other and to the underlying dielectric and metal layers. In some embodiments, a hardmask layer includes a layer of a nitride of silicon (e.g., silicon nitride) or a layer of an oxide of silicon, or both, or a combination thereof. Other suitable materials may include carbon-based materials. In another embodiment, a hardmask material includes a metal species. For example, a hardmask or other overlying material may include a layer of a nitride of titanium or another metal (e.g., titanium nitride). Potentially lesser amounts of other materials, such as oxygen, may be included in one or more of these layers. Alternatively, other hardmask layers known in the arts may be used depending upon the particular implementation. The hardmask layers maybe formed by CVD, PVD, or by other deposition methods.

In an embodiment, as is also used throughout the present description, lithographic operations are performed using 193nm immersion lithography (i193), extreme ultra-violet (EUV) lithography or electron beam direct write (EBDW) lithography, or the like. A positive tone or a negative tone resist may be used. In one embodiment, a lithographic mask is a trilayer mask composed of a topographic masking portion, an anti-reflective coating (ARC) layer, and a photoresist layer. In a particular such embodiment, the topographic masking portion is a carbon hardmask (CHM) layer and the anti-reflective coating layer is a silicon ARC layer.

Embodiments disclosed herein may be used to manufacture a wide variety of different types of integrated circuits or microelectronic devices. Examples of such integrated circuits include, but are not limited to, processors, chipset components, graphics processors, digital signal processors, micro-controllers, and the like. In other embodiments, semiconductor memory may be manufactured. Moreover, the integrated circuits or other microelectronic devices may be used in a wide variety of electronic devices known in the arts. For example, in computer systems (e.g., desktop, laptop, server), cellular phones, personal electronics, etc. The integrated circuits may be coupled with a bus and other components in the systems. For example, a processor may be coupled by one or more buses to a memory, a chipset, etc. Each of the processor, the memory, and the chipset, may potentially be manufactured using the approaches disclosed herein.

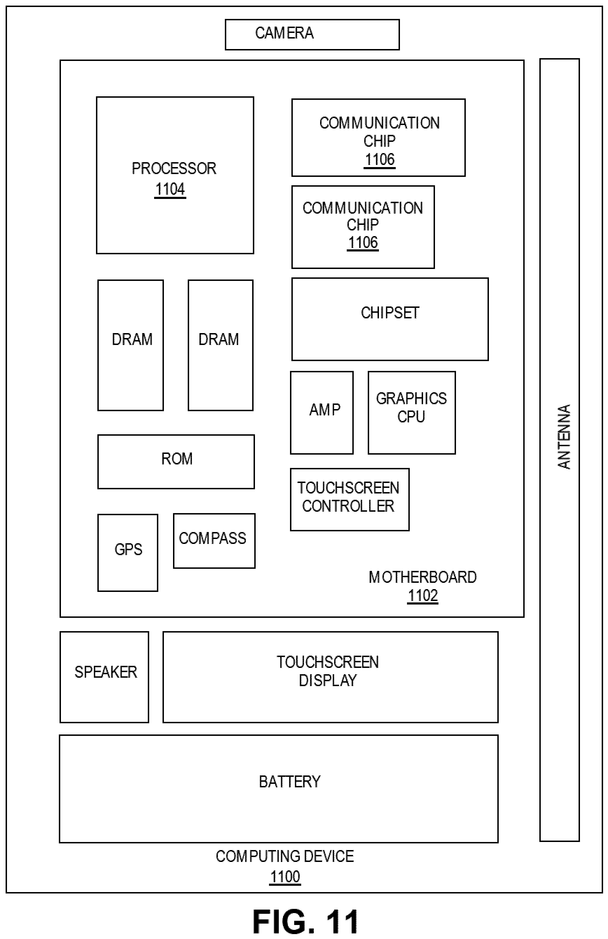

Figure 11 illustrates a computing device 1100 in accordance with one implementation of the disclosure. The computing device 1100 houses a board 1102. The board 1102 may include a number of components, including but not limited to a processor 1104 and at least one communication chip 1106. The processor 1104 is physically and electrically coupled to the board 1102. In some implementations the at least one communication chip 1106 is also physically and electrically coupled to the board 1102. In further implementations, the communication chip 1106 is part of the processor 1104.

Depending on its applications, computing device 1100 may include other components that may or may not be physically and electrically coupled to the board 1102. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 1106 enables wireless communications for the transfer of data to and from the computing device 1100. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1106 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 1100 may include a plurality of communication chips 1106. For instance, a first communication chip 1106 may be dedicated to shorter range wireless communications such as Wi-Fi and Bluetooth and a second communication chip 1106 may be dedicated to longer range wireless communications such as GPS, EDGE, GPRS, CDMA, WiMAX, LTE, Ev-DO, and others.

The processor 1104 of the computing device 1100 includes an integrated circuit die packaged within the processor 1104. In some implementations of embodiments of the disclosure, the integrated circuit die of the processor includes one or more structures, such as integrated circuit structures built in accordance with implementations of the disclosure. The term "processor" may refer to any device or portion of a device that processes electronic data from registers or memory to transform that electronic data, or both, into other electronic data that may be stored in registers or memory, or both.

The communication chip 1106 also includes an integrated circuit die packaged within the communication chip 1106. In accordance with another implementation of the disclosure, the integrated circuit die of the communication chip is built in accordance with implementations of the disclosure.

In further implementations, another component housed within the computing device 1100 may contain an integrated circuit die built in accordance with implementations of embodiments of the disclosure.

In various embodiments, the computing device 1100 may be a laptop, a netbook, a notebook, an ultrabook, a smartphone, a tablet, a personal digital assistant (PDA), an ultramobile PC, a mobile phone, a desktop computer, a server, a printer, a scanner, a monitor, a set-top box, an entertainment control unit, a digital camera, a portable music player, or a digital video recorder. In further implementations, the computing device 1100 may be any other electronic device that processes data.

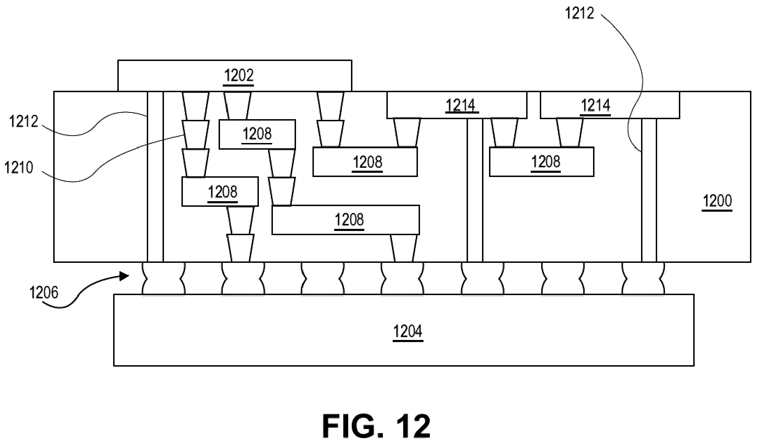

Figure 12 illustrates an interposer 1200 that includes one or more embodiments of the disclosure. The interposer 1200 is an intervening substrate used to bridge a first substrate 1202 to a second substrate 1204. The first substrate 1202 may be, for instance, an integrated circuit die. The second substrate 1204 may be, for instance, a memory module, a computer motherboard, or another integrated circuit die. Generally, the purpose of an interposer 1200 is to spread a connection to a wider pitch or to reroute a connection to a different connection. For example, an interposer 1200 may couple an integrated circuit die to a ball grid array (BGA) 1206 that can subsequently be coupled to the second substrate 1204. In some embodiments, the first and second substrates 1202/1204 are attached to opposing sides of the interposer 1200. In other embodiments, the first and second substrates 1202/1204 are attached to the same side of the interposer 1200. And in further embodiments, three or more substrates are interconnected by way of the interposer 1200.

The interposer 1200 may be formed of an epoxy resin, a fiberglass-reinforced epoxy resin, a ceramic material, or a polymer material such as polyimide. In further implementations, the interposer 1200 may be formed of alternate rigid or flexible materials that may include the same materials described above for use in a semiconductor substrate, such as silicon, germanium, and other group III-V and group IV materials.

The interposer 1200 may include metal interconnects 1208 and vias 1210, including but not limited to through-silicon vias (TSVs) 1212. The interposer 1200 may further include embedded devices 1214, including both passive and active devices. Such devices include, but are not limited to, capacitors, decoupling capacitors, resistors, inductors, fuses, diodes, transformers, sensors, and electrostatic discharge (ESD) devices. More complex devices such as radio-frequency (RF) devices, power amplifiers, power management devices, antennas, arrays, sensors, and MEMS devices may also be formed on the interposer 1200. In accordance with embodiments of the disclosure, apparatuses or processes disclosed herein may be used in the fabrication of interposer 1200 or in the fabrication of components included in the interposer 1200.

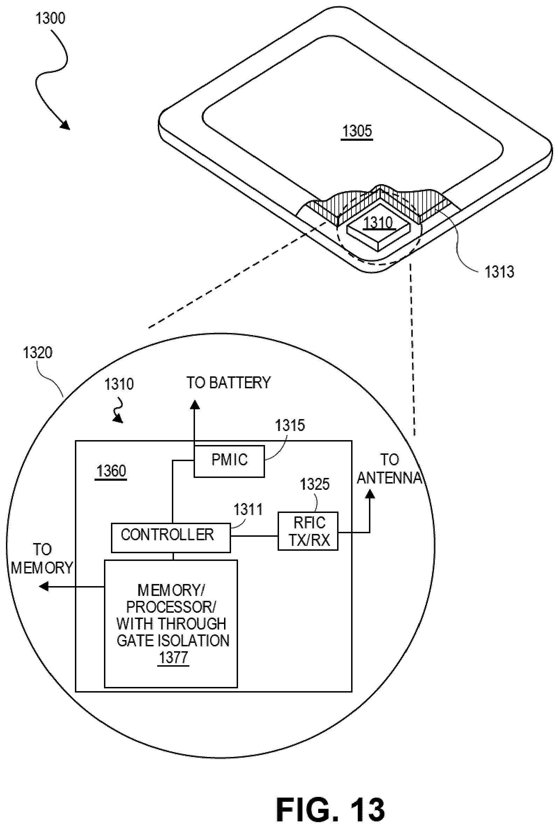

Figure 13 is an isometric view of a mobile computing platform 1300 employing an integrated circuit (IC) fabricated according to one or more processes described herein or including one or more features described herein, in accordance with an embodiment of the present disclosure.

The mobile computing platform 1300 may be any portable device configured for each of electronic data display, electronic data processing, and wireless electronic data transmission. For example, mobile computing platform 1300 may be any of a tablet, a smart phone, laptop computer, etc. and includes a display screen 1305 which in the exemplary embodiment is a touchscreen (capacitive, inductive, resistive, etc.), a chip-level (SoC) or package-level integrated system 1310, and a battery 1313. As illustrated, the greater the level of integration in the system 1310 enabled by higher transistor packing density, the greater the portion of the mobile computing platform 1300 that may be occupied by the battery 1313 or non-volatile storage, such as a solid state drive, or the greater the transistor gate count for improved platform functionality. Similarly, the greater the carrier mobility of each transistor in the system 1310, the greater the functionality. As such, techniques described herein may enable performance and form factor improvements in the mobile computing platform 1300.

The integrated system 1310 is further illustrated in the expanded view 1320. In the exemplary embodiment, packaged device 1377 includes at least one memory chip (e.g., RAM), or at least one processor chip (e.g., a multi-core microprocessor and/or graphics processor) fabricated according to one or more processes described herein or including one or more features described herein. The packaged device 1377 is further coupled to the board 1360 along with one or more of a power management integrated circuit (PMIC) 1315, RF (wireless) integrated circuit (RFIC) 1325 including a wideband RF (wireless) transmitter and/or receiver (e.g., including a digital baseband and an analog front end module further includes a power amplifier on a transmit path and a low noise amplifier on a receive path), and a controller thereof 1311. Functionally, the PMIC 1315 performs battery power regulation, DC-to-DC conversion, etc., and so has an input coupled to the battery 1313 and with an output providing a current supply to all the other functional modules. As further illustrated, in the exemplary embodiment, the RFIC 1325 has an output coupled to an antenna to provide to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. In alternative implementations, each of these board-level modules may be integrated onto separate ICs coupled to the package substrate of the packaged device 1377 or within a single IC (SoC) coupled to the package substrate of the packaged device 1377.

In another aspect, semiconductor packages are used for protecting an integrated circuit (IC) chip or die, and also to provide the die with an electrical interface to external circuitry. With the increasing demand for smaller electronic devices, semiconductor packages are designed to be even more compact and must support larger circuit density. Furthermore, the demand for higher performance devices results in a need for an improved semiconductor package that enables a thin packaging profile and low overall warpage compatible with subsequent assembly processing.

In an embodiment, wire bonding to a ceramic or organic package substrate is used. In another embodiment, a C4 process is used to mount a die to a ceramic or organic package substrate. In particular, C4 solder ball connections can be implemented to provide flip chip interconnections between semiconductor devices and substrates. A flip chip or Controlled Collapse Chip Connection (C4) is a type of mounting used for semiconductor devices, such as integrated circuit (IC) chips, MEMS or components, which utilizes solder bumps instead of wire bonds. The solder bumps are deposited on the C4 pads, located on the top side of the substrate package. In order to mount the semiconductor device to the substrate, it is flipped over with the active side facing down on the mounting area. The solder bumps are used to connect the semiconductor device directly to the substrate.

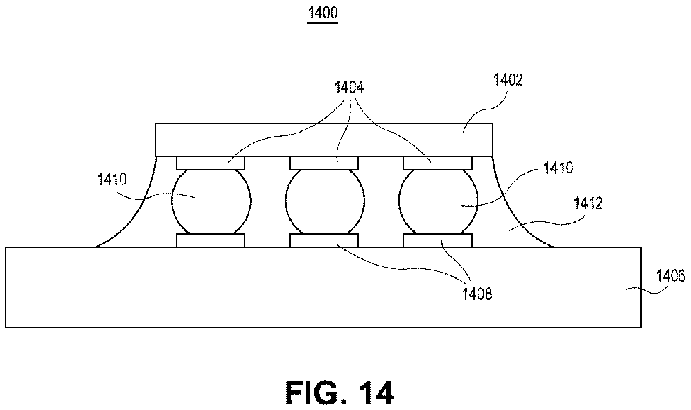

Figure 14 illustrates a cross-sectional view of a flip-chip mounted die, in accordance with an embodiment of the present disclosure.

Referring to Figure 14, an apparatus 1400 includes a die 1402 such as an integrated circuit (IC) fabricated according to one or more processes described herein or including one or more features described herein, in accordance with an embodiment of the present disclosure. The die 1402 includes metallized pads 1404 thereon. A package substrate 1406, such as a ceramic or organic substrate, includes connections 1408 thereon. The die 1402 and package substrate 1406 are electrically connected by solder balls 1410 coupled to the metallized pads 1404 and the connections 1408. An underfill material 1412 surrounds the solder balls 1410.

Processing a flip chip may be similar to conventional IC fabrication, with a few additional operations. Near the end of the manufacturing process, the attachment pads are metalized to make them more receptive to solder. This typically consists of several treatments. A small dot of solder is then deposited on each metalized pad. The chips are then cut out of the wafer as normal. To attach the flip chip into a circuit, the chip is inverted to bring the solder dots down onto connectors on the underlying electronics or circuit board. The solder is then re-melted to produce an electrical connection, typically using an ultrasonic or alternatively reflow solder process. This also leaves a small space between the chip's circuitry and the underlying mounting. In most cases an electrically-insulating adhesive is then "underfilled" to provide a stronger mechanical connection, provide a heat bridge, and to ensure the solder joints are not stressed due to differential heating of the chip and the rest of the system.

In other embodiments, newer packaging and die-to-die interconnect approaches, such as through silicon via (TSV) and silicon interposer, are implemented to fabricate high performance Multi-Chip Module (MCM) and System in Package (SiP) incorporating an integrated circuit (IC) fabricated according to one or more processes described herein or including one or more features described herein, in accordance with an embodiment of the present disclosure.

Thus, embodiments of the present disclosure include advanced integrated circuit structure fabrication and, in particular, metal lines patterned by bottom-up fill metallization and the resulting structures.

Although specific embodiments have been described above, these embodiments are not intended to limit the scope of the present disclosure, even where only a single embodiment is described with respect to a particular feature. Examples of features provided in the disclosure are intended to be illustrative rather than restrictive unless stated otherwise. The above description is intended to cover such alternatives, modifications, and equivalents as would be apparent to a person skilled in the art having the benefit of the present disclosure.

The scope of the present disclosure includes any feature or combination of features disclosed herein (either explicitly or implicitly), or any generalization thereof, whether or not it mitigates any or all of the problems addressed herein. Accordingly, new claims may be formulated during prosecution of the present application (or an application claiming priority thereto) to any such combination of features. In particular, with reference to the appended claims, features from dependent claims may be combined with those of the independent claims and features from respective independent claims may be combined in any appropriate manner and not merely in the specific combinations enumerated in the appended claims.

The following examples pertain to further embodiments. The various features of the different embodiments may be variously combined with some features included and others excluded to suit a variety of different applications.
Example embodiment 1: An integrated circuit structure includes a plurality of conductive interconnect lines above a substrate, individual ones of the conductive interconnect lines having a top and sidewalls. An etch stop layer is on the top and along an entirety of the sidewalls of the individual ones of the conductive interconnect lines.
Example embodiment 2: The integrated circuit structure of example embodiment 1, wherein the individual ones of the conductive interconnect lines include a conductive fill layer on a seed layer.
Example embodiment 3: The integrated circuit structure of example embodiment 2, wherein the conductive fill layer includes a metal selected from the group consisting of Cu, Ni, Co, Ru, Pt and Ir.
Example embodiment 4: The integrated circuit structure of example embodiment 2 or 3, wherein the seed layer includes titanium nitride and ruthenium.
Example embodiment 5: The integrated circuit structure of example embodiment 2 or 3, wherein the seed layer includes tantalum and copper.
Example embodiment 6: The integrated circuit structure of example embodiment 1, 2, 3, 4 or 5, further including an inter-layer dielectric (ILD) material between adjacent ones of the individual ones of the conductive interconnect lines, the ILD material laterally adjacent to and in contact with the portion of the etch stop layer along the entirety of the sidewalls of the individual ones of the conductive interconnect lines.
Example embodiment 7: The integrated circuit structure of example embodiment 1, 2, 3, 4 or 5, further including an air gap between adjacent ones of the individual ones of the conductive interconnect lines, the air gap laterally adjacent to the portion of the etch stop layer along the entirety of the sidewalls of the individual ones of the conductive interconnect lines.
Example embodiment 8: The integrated circuit structure of example embodiment 1, 2, 3, 4, 5, 6 or 7, further including an inter-layer dielectric (ILD) layer on and in contact with the portion of the etch stop layer along the top surfaces of the individual ones of the conductive interconnect lines.
Example embodiment 9: The integrated circuit structure of example embodiment 8, further including a conductive via in an opening through the ILD layer and through the etch sop layer, the conductive via in contact with one of the individual ones of the conductive interconnect lines.
Example embodiment 10: A method of fabricating an integrated circuit structure includes forming a seed layer above a substrate, forming a pattern of sacrificial material structures on the seed layer, forming a conductive fill layer on the seed layer and between the sacrificial material structures, removing the pattern of sacrificial material structures, patterning the seed layer using the conductive fill layer as a mask, and forming an etch stop layer over and along sidewalls of the conductive fill layer and the patterned seed layer.
Example embodiment 11: The method of example embodiment 10, wherein the conductive fill layer includes a metal selected from the group consisting of Cu, Ni, Co, Ru, Pt and Ir.
Example embodiment 12: The method of example embodiment 10 or 11, wherein the seed layer includes titanium nitride and ruthenium.
Example embodiment 13: The method of example embodiment 10 or 11, wherein the seed layer includes tantalum and copper.
Example embodiment 14: The method of example embodiment 10, 11, 12 or 13, further including forming an inter-layer dielectric (ILD) material laterally adjacent to and in contact with the portion of the etch stop layer along the sidewalls of the conductive fill layer and the patterned seed layer.
Example embodiment 15: The method of example embodiment 10, 11, 12, 13 or 14, further including forming an inter-layer dielectric (ILD) layer on and in contact with a portion of the etch stop layer along a top surface of the conductive fill layer.
Example embodiment 16: A computing device includes a board, and a component coupled to the board. The component includes an integrated circuit structure including a plurality of conductive interconnect lines above a substrate, individual ones of the conductive interconnect lines having a top and sidewalls. An etch stop layer is on the top and along an entirety of the sidewalls of the individual ones of the conductive interconnect lines.
Example embodiment 17: The computing device of example embodiment 16, further including a memory coupled to the board.
Example embodiment 18: The computing device of example embodiment 16 or 17, further including a communication chip coupled to the board.
Example embodiment 19: The computing device of example embodiment 16, 17 or 18, further including a camera coupled to the board.
Example embodiment 20: The computing device of example embodiment 16, 17, 18 or 19, wherein the component is a packaged integrated circuit die.

## Claims

1. An integrated circuit structure, comprising:
a plurality of conductive interconnect lines above a substrate, individual ones of the conductive interconnect lines having a top and sidewalls; and
an etch stop layer on the top and along an entirety of the sidewalls of the individual ones of the conductive interconnect lines.

2. The integrated circuit structure of claim 1, wherein the individual ones of the conductive interconnect lines comprise a conductive fill layer on a seed layer.

3. The integrated circuit structure of claim 2, wherein the conductive fill layer comprises a metal selected from the group consisting of Cu, Ni, Co, Ru, Pt and Ir.

4. The integrated circuit structure of claim 2 or 3, wherein the seed layer comprises titanium nitride and ruthenium.

5. The integrated circuit structure of claim 2 or 3, wherein the seed layer comprises tantalum and copper.

6. The integrated circuit structure of claim 1, 2, 3, 4 or 5, further comprising:
an inter-layer dielectric (ILD) material between adjacent ones of the individual ones of the conductive interconnect lines, the ILD material laterally adjacent to and in contact with the portion of the etch stop layer along the entirety of the sidewalls of the individual ones of the conductive interconnect lines.

7. The integrated circuit structure of claim 1, 2, 3, 4 or 5, further comprising:
an air gap between adjacent ones of the individual ones of the conductive interconnect lines, the air gap laterally adjacent to the portion of the etch stop layer along the entirety of the sidewalls of the individual ones of the conductive interconnect lines.

8. The integrated circuit structure of claim 1, 2, 3, 4, 5, 6 or 7, further comprising:
an inter-layer dielectric (ILD) layer on and in contact with the portion of the etch stop layer along the top surfaces of the individual ones of the conductive interconnect lines.

9. The integrated circuit structure of claim 8, further comprising:
a conductive via in an opening through the ILD layer and through the etch sop layer, the conductive via in contact with one of the individual ones of the conductive interconnect lines.

10. A method of fabricating an integrated circuit structure, the method comprising:
forming a seed layer above a substrate;
forming a pattern of sacrificial material structures on the seed layer;
forming a conductive fill layer on the seed layer and between the sacrificial material structures;
removing the pattern of sacrificial material structures;
patterning the seed layer using the conductive fill layer as a mask; and
forming an etch stop layer over and along sidewalls of the conductive fill layer and the patterned seed layer.

11. The method of claim 10, wherein the conductive fill layer comprises a metal selected from the group consisting of Cu, Ni, Co, Ru, Pt and Ir.

12. The method of claim 10 or 11, wherein the seed layer comprises titanium nitride and ruthenium.

13. The method of claim 10 or 11, wherein the seed layer comprises tantalum and copper.

14. The method of claim 10, 11, 12 or 13, further comprising:
forming an inter-layer dielectric (ILD) material laterally adjacent to and in contact with the portion of the etch stop layer along the sidewalls of the conductive fill layer and the patterned seed layer.

15. The method of claim 10, 11, 12, 13 or 14, further comprising:
forming an inter-layer dielectric (ILD) layer on and in contact with a portion of the etch stop layer along a top surface of the conductive fill layer.
